# EUROPEAN PATENT SPECIFICATION

(11) **EP 4 231 486 B1**
(45) Date of publication and mention of the grant of the patent: **28.05.2025**
(21) Application number: 22883782.9
(22) Date of filing: 13.09.2022
(51) Int. Cl.: H02J 7/00, H03K 17/687, H03K 19/20

(54) **CURRENT CONSUMPTION CONTROL DEVICE AND BATTERY MANAGEMENT DEVICE COMPRISING SAME**
STROMVERBRAUCHSSTEUERUNGSVORRICHTUNG UND BATTERIEVERWALTUNGSVORRICHTUNG DAMIT
DISPOSITIF DE COMMANDE DE CONSOMMATION DE COURANT ET DISPOSITIF DE GESTION DE BATTERIE LE COMPRENANT

(30) Priority: 19.10.2021 KR 20210138962
(43) Date of publication of application: 23.08.2023
(73) Proprietor: LG Energy Solution, Ltd., Seoul 07335 (KR)
(72) Inventor: KIM, Jeong Wook, Daejeon 34122 (KR); KIM, Ha Yong, Daejeon 34122 (KR); LEE, Sangkyu, Daejeon 34122 (KR); LEE, Suk Hoon, Daejeon 34122 (KR); CHOI, Bum, Daejeon 34122 (KR)
(74) Representative: Plasseraud IP
(86) International application number: PCT/KR2022/013625
(87) International publication number: WO 2023/068557

(56) References cited:
- JP-A- 2013 236 492
- JP-A- 2016 073 022
- KR-A- 20180 062 539
- KR-A- 20210 097 950
- US-A1- 2017 163 064
- US-A1- 2019 067 957
- US-A1- 2020 052 346
- US-A1- 2021 013 723
- US-B2- 9 766 276

## Description

### [Technical Field]

This application claims priority to and the benefit of Korean Patent Application No.10-2021-0138962 filed in the Korean Intellectual Property Office on October 19, 2021.

The present invention relates to a current consumption control apparatus and a battery management system including the same, and more particularly, to a current consumption control circuit that minimizes current consumption in hardware and a battery management system including the same.

### [Background Art]

Secondary batteries are batteries that can be recharged and reused repeatedly. Secondary batteries are typically manufactured as a battery module or a battery pack formed by connecting a plurality of battery cells in series according to a required output capacity and used as power supply sources for various devices. Such batteries are being used in various fields ranging from small high-tech electronic devices such as smart phones to electric bicycles, vacuum cleaners, electric vehicles (EVs, Light EVs), and energy storage systems (ESS).

A battery module or battery pack is a structure in which a plurality of battery cells are combined. When overvoltage, overcurrent, or overheating occurs in some battery cells, a problem occurs in safety and operating efficiency of the battery module or battery pack. Thus, solutions for detecting these problems are essential. Accordingly, a battery module or battery pack is equipped with a battery management system (BMS) that measures a voltage value of each battery cell, and monitors and controls voltage states of battery cells based on measured values.

When a battery pack is left unattended for a long time, it frequently occurs that the battery pack cannot be used permanently because it has been overdischarged due to current consumption. Due to this problem, a method of reducing usable capacity is used for expensive battery packs, for example, a state with a certain capacity remaining is used as SOC 0%, which is inefficient.

In addition, a method of minimizing current consumption in software by turning off functions of MCU and BMIC in the BMS as much as possible is generally used. However, proper hardware approaches have not sufficiently presented for reducing current consumption of the BMS. US2020/052346 A1, US2017/163064 and US2019/067957 each relate to BMS wake-up devices.

### [Summary]

### [Technical Problem]

Embodiments of the present disclosure provide an apparatus for controlling current consumption of a battery management system (BMS).

Embodiments of the present disclosure also provide a battery management system (BMS) including a current consumption control circuit.

### [Technical Solution]

In order to achieve the objective of the present disclosure, an apparatus according to claim 1 is provided in a first aspect.

The apparatus for controlling current consumption of BMS may further comprise an output unit configured to output a current consumption control signal received from the operation unit to the at least one component in the BMS.

The at least one component in the BMS may include a micro controller unit (MCU) and a current supply device.

Meanwhile, the control circuit may further include a switch for generating a signal for activating the entire circuit in the operation unit according to an output of the logic element.

In case that both the charger connection signal and the always constant power source off signal being input high, the operation unit may become deactivated.

Driving voltages of the plurality of MOSFETs included in the control circuit are set to the same value or different values according to an operation target of an individual circuit including the MOSFETs.

Furthermore, the resistance values of the plurality of resistance elements included in the control circuit are set to the same value or different values according to an operation target of an individual circuit including the resistance elements.

In case that both the charger connection signal and the always constant power source off signal being input high, the operation unit may become deactivated.

Here, the power supply is a low drop-output (LDO) regulator.

### [Advantageous Effects]

According to embodiments of the present disclosure, a current consumption control circuit as a hardware approach capable of minimizing current consumption of a battery management system is proposed, by which current consumption can be minimized through turning off power source-related circuits in a battery management system in hardware when battery discharge occurs more than necessary.

### [Brief Description of the Drawings]

FIG. 1 shows a block diagram of a battery system including an apparatus for controlling current consumption according to embodiments of the present invention.
FIG. 2 is a block diagram of an apparatus for controlling current consumption according to embodiments of the present invention.
FIG. 3 is a circuit diagram of an operation unit of an apparatus for controlling current consumption according to embodiments of the present invention.
FIG. 4 is a table for explaining states of elements in an apparatus for controlling current consumption according to changes in current consumption according to embodiments of the present invention.

### [Detailed Description]

Accordingly, while the invention is susceptible to various modifications and alternative forms, specific embodiments thereof are shown by way of example in the drawings and will herein be described in detail. It should be understood, however, that there is no intent to limit the invention to the particular forms disclosed, but on the contrary, the invention is to cover all modifications, equivalents, and alternatives falling within the spirit and scope of the invention. Like numbers refer to like elements throughout the description of the figures.

It will be understood that, although the terms first, second, A, B, etc. may be used herein to describe various elements, these elements should not be limited by these terms. These terms are only used to distinguish one element from another. For example, a first element could be termed a second element, and, similarly, a second element could be termed a first element, without departing from the scope of the present invention. As used herein, the term "and/or" includes any and all combinations of one or more of the associated listed items.

It will be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present. Other words used to describe the relationship between elements should be interpreted in a like fashion (i.e., "between" versus "directly between", "adjacent" versus "directly adjacent", etc.).

The terminology used herein is for the purpose of describing particular embodiments only and is not intended to be limiting of the invention. As used herein, the singular forms "a", "an" and "the" are intended to include the plural forms as well, unless the context clearly indicates otherwise. It will be further understood that the terms "comprises", "comprising,", "includes" and/or "including", when used herein, specify the presence of stated features, integers, steps, operations, elements, and/or components, but do not preclude the presence or addition of one or more other features, integers, steps, operations, elements, components, and/or groups thereof.

Unless otherwise defined, all terms (including technical and scientific terms) used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

Hereinafter, exemplary embodiments of the present invention will be described in detail with reference to the accompanying drawings.

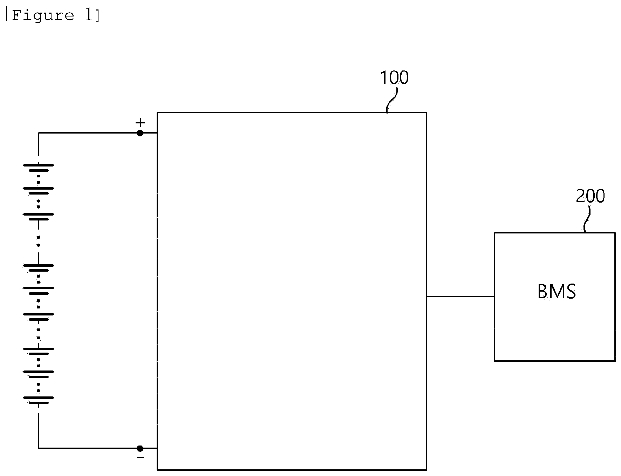

FIG. 1 shows a block diagram of a battery system including an apparatus for controlling current consumption according to embodiments of the present invention.

In FIG. 1, a battery pack or battery module may include a plurality of battery cells connected in series. The battery pack or module may be connected to a load through a positive terminal and a negative terminal to perform charging or discharging.

A battery management system (BMS) 200 may be installed in a battery module or battery pack. The BMS may monitor a current, a voltage and a temperature of each battery pack to be managed, calculate a state of charge (SOC) of the battery based on monitoring results to control charging and discharging. Here, the State of Charge (SOC) refers to a current state of charge of a battery, represented in percent points [%], and a State of Health (SOH) ) may be a current condition of a battery comprated to its ideal conditions, represented in percent points [%].

The BMS 200 may include various components such as a fuse, a current sensing element, a thermistor, a switch, and a balancer to perform such operations. In most cases, a micro controller unit (MCU) or a battery monitoring integrated chip (BMIC) for interworking and controlling these components is additionally included in the BMS. Here, the BMIC may be located inside the BMS and may be an integrated circuit (IC) type component that measures information such as voltage, temperature, and current of a battery cell/module.

The current consumption control apparatus 100 according to embodiments of the present invention is located between a battery pack and a BMS 200, and may have an input connected to a positive terminal and a negative terminal of the battery pack, and an output connected to the BMS. In addition, the current consumption control apparatus 100 according to the present invention may be implemented in a form included in the BMS as a part of the BMS.

In the insatace that the current consumption control apparatus according to embodiments of the present invention is implemented as a part of the BMS, the BMS may include a current consumption control circuit including a logic element to which a charger connection signal and an always constant power source off signal are input, a plurality of switches, a plurality of operational amplifiers, and a plurality of resistance elements, wherein the current consumption control circuit is configured to generate a current consumption control signal according to an output of the logic element and an output voltage of the battery pack; a main controller that is configured to receive the current consumption control signal and operate in a current consumption minimizing method; and a power supply that stops supply of switched power or always constant power in response to receiving the current consumption control signal.

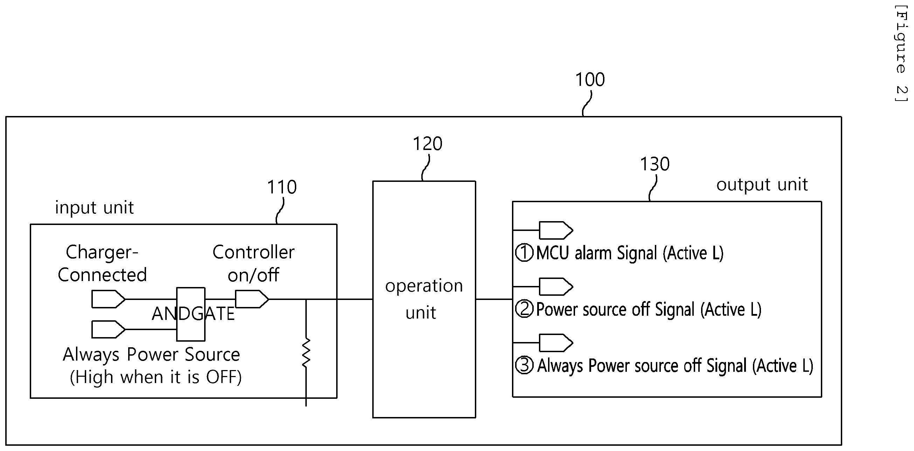

FIG. 2 is a block diagram of an apparatus for controlling current consumption according to embodiments of the present invention.

The apparatus for controlling current consumption 100 according to embodiments of the present invention is an apparatus for controlling current consumption of a BMS (Battery Management System) that manages a battery pack. The apparatus for controlling current consumption 100 may comprise an input unit (110) including a logic element to which a charger connection signal and an always constant power source off signal are input; an operation unit (120) including a control circuit, wherein control circuit includes a plurality of switches, a plurality of operational amplifiers, and a plurality of resistance elements, and wherein the operation unit is configured to generate a current consumption control signal for at least one component in the BMS according to an output of the logic element and an output voltage of the battery pack; and an output unit (130) configured to output a current consumption control signal received from the operation unit to at least one element in the BMS.

The input unit 110 may include an AND gate that is a logic element. A first input of the AND gate is a charger connection signal and a second input of the AND gate is an always constant power source OFF signal. The output of the AND gate is input to the operation unit 120 including a current consumption control circuit according to embodiments of the present invention. In other words, the current consumption control circuit may be activated or deactivated according to the output signal of the AND gate.

The output unit 130 of the current consumption control apparatus 100 may receive at least one of an MCU alarm signal, a switched power source OFF signal, and an always constant power source OFF signal received from the operation unit 120, and may transmit it to the BMS.

Meanwhile, the always constant power source OFF signal, which is the second input of the input unit 110, may be a signal provided to the input unit by inverting the always constant power source OFF signal which is transmitted from the output unit 130 to a power supply.

Among three signals output by the output unit 130, the MCU alarm signal may be transmitted to a micro controller unit (MCU) in the BMS in hardware. The MCU operates in a manner that minimizes current consumption based on the alarm signal. For example, the MCU may be forced to enter and operate in a sleep mode.

Meanwhile, the switched power source off signal and the always constant power source OFF signal may be transmitted to a power supply device in the BMS. The power supply device may be, for example, an low drop-output (LDO) regulator. The LDO regulator is a linear regulator that operates even with a low input/output potential difference. The LDO regulator is a power-efficient power supply device that supplies power to key components of BMS such as a MCU, a CAN communication IC, and an isolator IC.

The LDO regulator may always supply a constant voltage (eg, 3.3V) or a switched 3.3V voltage depending on a device to be powered. For example, a device such as a Real Time Clock (RTC) is a circuit part that is always powered on regardless of whether the BMS is operating or not. On the other hand, major ICs such as a MCU and a communication IC operate by receiving a switched power source.

Upon receiving the switched power-off signal, the power supply device stops supplying switched power to major ICs such as MCUs and communication ICs. In other words, according to embodiments of the present invention, when a voltage of the battery reaches a voltage corresponding to an full (or over) discharge level, the power supply to the IC devices is forcibly turned off through hardware rather than a firmware operation of the MCU.

In addition, the power supply device that has received the always constant power source off signal may stops the always constant power supply to circuits that are normally always supplied with power. In other words, according to embodiments of the present invention, when a voltage of the battery exceeds an over-discharge level and reaches a dangerous level, the power supply to all components inside the BMS is forcibly turned off.

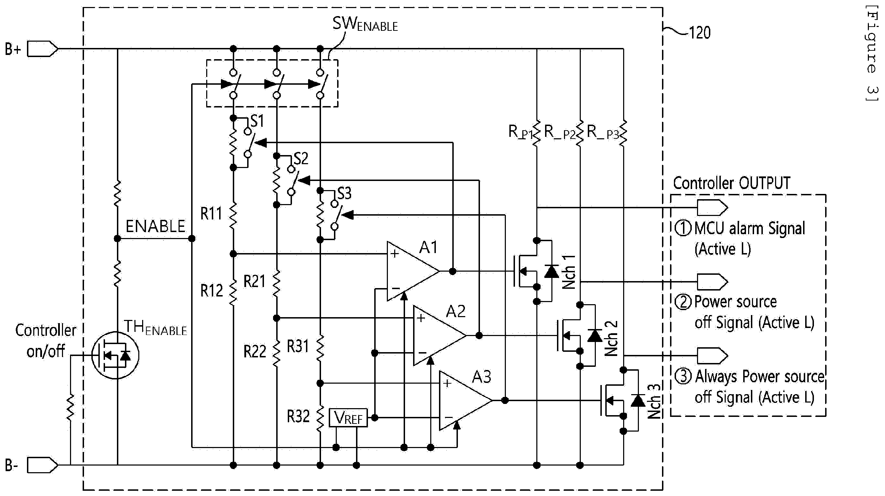

FIG. 3 is a circuit diagram of an operation unit of an apparatus for controlling current consumption according to embodiments of the present invention.

As shown in FIG. 3, the operation unit 120 may include a plurality of resistors for voltage division, a plurality of switches, a plurality of operational amplifiers, and a plurality of MOSFETs.

The control circuit ON/OFF signal from the input unit is input to a gate of the entire circuit enable switch TH_{ENABLE} in the operation unit. When the entire circuit enable switch TH_{ENABLE}, that is, the MOSFET is ON (High), the enable signal (ENABLE) becomes low to turn off the entire circuit of the operation unit 120. On the other hand, when the MOSFET is Off (Low), ON state ENABLE signal is input to circuit elements in the operation unit. The on-state ENABLE signal turns on individual circuit activation switches SW_{ENABLE}.

Each individual circuit enable switch SW_{ENABLE} may be connected to a first individual circuit (including a first switch S1, a first operational amplifier A1, and a first MOSFET Nch 1), a second individual circuit (including second switch S2, a second operational amplifier A2, and a second MOSFET Nch 2), or a third individual circuit (including a third switch S3, a third operational amplifier A3, and a third MOSFET Nch 3). Each individual circuit may further include a pull-up resistor element (R__{P1}, R__{P2}, or R__{P3}) connected to a positive terminal of the battery and at least one resistor element (R₁₁, R₁₂, R₂₁, R₂₂, R₃₁, R₃₂) for voltage division.

In the circuit of FIG. 3, the first MOSFET, the second MOSFET, and the third MOSFET are implemented as N-channel MOSFETs, but it also is possible to implement a current consumption control circuit according to embodiments of the present invention by using P-channel MOSFETs through appropriate configuration changes of circuit.

The first individual circuit may include a first switch S1, a first operational amplifier A1, and a first MOSFET Nch1 to output an MCU alarm signal. More specifically, when a voltage output from the positive terminal of the battery decreases, a divided voltage applied to the first operational amplifier A1 becomes lower than a reference voltage V_{ref}, and the output of the first operational amplifier becomes High. When the output of the first operational amplifier A1 is input to the gate of the first MOSFET and the first MOSFET is turned on, the output of the first MOSFET is changed from High to Low. In the instance that the battery pack is switched to a charged state, the entire circuit in the operation unit becomes deactivated, and accordingly, the first MOSFET is also turned off and the output of the first MOSFET is restored to high again.

Here, the first switch S1 and a resistor connected in parallel with the first switch are elements for maintaining the output of the first operational amplifier A1.

The second individual circuit may include a second switch S2, a second operational amplifier A2, and a second MOSFET Nch2 to output a switched power source off signal. More specifically, when a voltage output from the positive electrode terminal of the battery decreases, a divided voltage applied to the second operational amplifier A2 becomes lower than the reference voltage Vref, and the output of the second operational amplifier becomes high. When the output of the second operational amplifier is input to the gate of the second MOSFET and the second MOSFET is turned on, the output of the second MOSFET is changed from High to Low. In the instance that the battery pack is switched to a charged state, the entire circuit in the operation unit becomes deactivated, the second MOSFET is also turned off accordingly, and the output of the second MOSFET is restored to high again.

Here, the second switch S2 and a resistor connected in parallel with the second switch are elements for maintaining the output of the second operational amplifier A2.

The third individual circuit may include a third switch S3, a third operational amplifier A3, and a third MOSFET Nch3 to output an always constant power source off signal. More specifically, when a voltage output from the battery positive terminal decreases, a divided voltage applied to the third operational amplifier A3 becomes lower than the reference voltage Vref, and the output of the third operational amplifier becomes high. When the output of the third operational amplifier is input to the gate of the third MOSFET and the third MOSFET is turned on, the output of the third MOSFET is changed from High to Low. In the instance tha the battery pack is switched to a charged state, the entire circuit in the operation section becomes deactivated and accordingly the third MOSFET is also turned off and the output of the third MOSFET is restored to high again.

Here, the third switch S3 and the resistor connected in parallel with the third switch are elements for maintaining the output of the third operational amplifier A2.

Here, driving voltages of the first MOSFET Nch1, the second MOSFET Nch2, and the third MOSFET Nch3 may be set identically or differently depending on an operation target for each individual circuit. In addition, the values of the at least one resistance elements R11, R12, R21, R22, R31, and R32 for voltage division may also be set to identically or differently according to an operation target for each individual circuit.

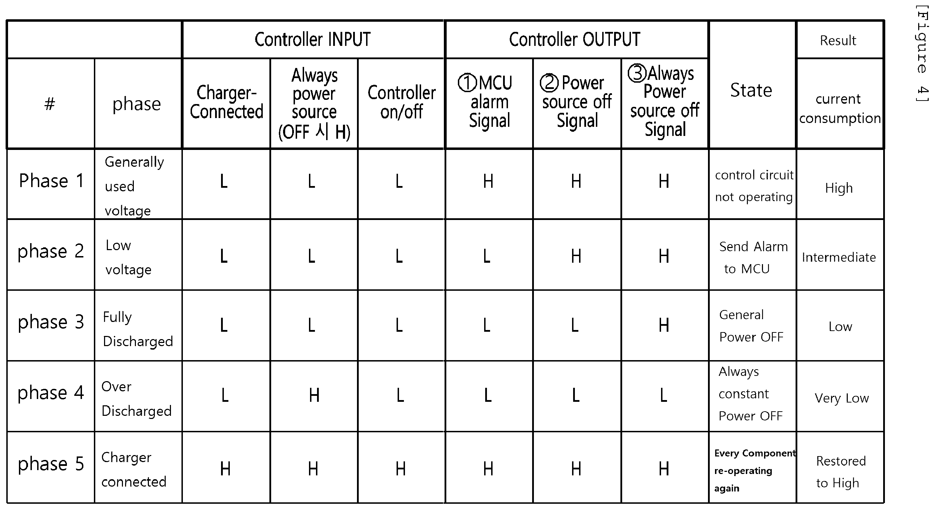

FIG. 4 is a table for explaining states of elements in an apparatus for controlling current consumption according to changes in current consumption according to embodiments of the present invention.

In the table of FIG. 4, phase 1 indicates a normal battery and BMS situation, and accordingly indicates a case where a battery output is a generally used voltage. Phase 2 represents a case in which the battery output has a voltage lower than a voltage generally used while power consumption is gradually increasing. Phase 3 represents a case in which power consumption has further increased to reach full discharge, and phase 4 represents a case in which overdischarge is reached.

As described above, the input signals to the current consumption control circuit is a charger connection signal and an always constant power source OFF signal. When one of these signals is low, the output signal of the AND gate becomes low and an activation signal is applied to to control circuit (when the controller on/off signal is Low).

That is, in the cases of phases 1 to 4, the activation signal to the current consumption control circuit is applied.

However, in phase 1, the activation signal for the entire current consumption control circuit is applied, but since the voltage output by the battery pack is sufficiently high, the output of the operational amplifier in the individual circuit becomes low and thus, there is no signal output by the current consumption control circuit.

In phase 2, the first individual circuit is activated to output an MCU alarm signal (Active Low). In phase 3, the second individual circuit is activated to output a switched power source off signal (Active Low). Furthermore, in the case of state 4, the third individual circuit is activated to output a always constant power source OFF signal (Active Low).

On the other hand, phase 5 indicates a case in which a charger is connected to the battery pack. In this case, the controller OFF signal becomes HIGH and the current consumption control circuit does not operate. In other words, since the current consumption control circuit does not operate, all components included in the BMS operate normally and the current consumption level is restored to high.

The embodiments of the present disclosure may be implemented as program instructions executable by a variety of computers and recorded on a computer readable medium. The computer readable medium may include a program instruction, a data file, a data structure, or a combination thereof. The program instructions recorded on the computer readable medium may be designed and configured specifically for the present disclosure or can be publicly known and available to those who are skilled in the field of computer software.

While the example embodiments of the present invention and their advantages have been described in detail, it should be understood that various changes, substitutions and alterations may be made herein without departing from the scope of the claims.

## Claims

1. An apparatus (100) for controlling current consumption of a battery management system, BMS (200) managing a battery pack, the apparatus (100) comprising:
an input unit (110) including an AND gate to which a charger connection signal and an always constant power source off signal are input, wherein the always constant power source off signal is the inversion of a signal indicating that a power supply to circuits in the BMS (200) that are normally always supplied with power is to be stopped;
an operation unit (120) including a control circuit, wherein the control circuit includes a plurality of switches, a plurality of operational amplifiers, and a plurality of resistance elements wherein the control circuit includes:
a first individual circuit comprising:
an operational amplifier that is configured to have a voltage value related to a voltage output from the battery pack as a first input; and
a MOSFET that is configured to have the output voltage of the operational amplifier as a driving voltage and to output a micro controller unit, MCU, alarm signal;
a second individual circuit comprising:
an operational amplifier that is configured to have a voltage value related to a voltage output from the battery pack as a first input; and
a MOSFET that is configured to have the output voltage of the operational amplifier as a driving voltage and to output a switched power source off signal, and
a third individual circuit comprising:
an operational amplifier that is configured to have a voltage value related to a voltage output from the battery pack as a first input; and
a MOSFET that is configured to have the output voltage of the operational amplifier as a driving voltage and to output an always constant power source off signal
wherein each operational amplifier is configured to have a reference voltage as a second input, and
wherein the operation unit (120) is configured to generate a current consumption control signal using the output from the MOSFETs for at least one component in the BMS (200) according to an output of the AND gate and an output voltage of the battery pack.

2. The apparatus of claim 1, further comprising an output unit (130) configured to output a current consumption control signal received from the operation unit to the at least one component in the BMS (200).

3. The apparatus of claim 1, wherein the control circuit further includes a switch (SWenable) for generating a signal for activating the entire circuit in the operation unit (120) according to an output of the AND gate.

4. The apparatus of claim 1, wherein, upon both the charger connection signal and the always constant power source off signal being input high, the operation unit (120) becomes deactivated.

5. The apparatus of claim 1, wherein driving voltages of the plurality of MOSFETs included in the control circuit are set to the same value or different values according to an operation target of an individual circuit including the MOSFETs.

6. The apparatus of claim 1, wherein the resistance values of the plurality of resistance elements included in the control circuit are set to the same value or different values according to an operation target of an individual circuit including the resistance elements.

7. A battery management apparatus according to claim 1, further comprising
a power supply that stops supply of switched power or always constant power in response to receiving the current consumption control signal.

## Patentansprüche

1. Vorrichtung (100) zum Steuern eines Stromverbrauchs eines Batterie-Verwaltungssystems, BMS (200), welches einen Batteriepack verwaltet, wobei die Vorrichtung (100) umfasst:
eine Eingabeeinheit (110), welche ein AND-Gate umfasst, an welches ein Ladegerät-Verbindungssignal und ein Aus-Signal einer immer konstanten Stromquelle eingegeben werden, wobei das Aus-Signal der immer konstanten Stromquelle die Inversion eines Signals ist, welches anzeigt, dass eine Stromversorgung zu Schaltungen in dem BMS (200), welche normalerweise immer mit Strom versorgt werden, zu stoppen ist;
eine Betriebseinheit (120), welche eine Steuerschaltung umfasst, wobei die Steuerschaltung eine Mehrzahl von Schaltern, eine Mehrzahl von Operationsverstärkern und eine Mehrzahl von Widerstandselementen umfasst,
wobei die Steuerschaltung umfasst:
eine erste individuelle Schaltung, umfassend:
einen Operationsverstärker, welcher dazu eingerichtet ist, einen Spannungswert, welcher mit einer Spannungsausgabe von dem Batteriepack in Bezug steht, als eine erste Eingabe aufzuweisen; und
einen MOSFET, welcher dazu eingerichtet ist, die Ausgabespannung des Operationsverstärkers als eine Treiberspannung aufzuweisen und ein Mikrocontroller-Einheit-, MCU-, Alarmsignal auszugeben;
eine zweite individuelle Schaltung, umfassend:
einen Operationsverstärker, welcher dazu eingerichtet ist, einen Spannungswert, welcher mit einer Spannungsausgabe von dem Batteriepack in Bezug steht, als eine erste Eingabe aufzuweisen; und
einen MOSFET, welcher dazu eingerichtet ist, die Ausgabespannung des Operationsverstärkers als eine Treiberspannung aufzuweisen und ein Aus-Signal einer geschalteten Stromquelle auszugeben, und
eine dritte individuelle Schaltung, umfassend:
einen Operationsverstärker, welcher dazu eingerichtet ist, einen Spannungswert,
welcher mit einer Ausgabespannung von dem Batteriepack in Bezug steht, als eine erste Eingabe aufzuweisen; und
einen MOSFET, welcher dazu eingerichtet ist, die Ausgabespannung des Operationsverstärkers als eine Treiberspannung aufzuweisen und ein Aus-Signal einer immer konstanten Stromquelle auszugeben,
wobei jeder Operationsverstärker dazu eingerichtet ist, eine Referenzspannung als eine zweite Eingabe aufzuweisen, und
wobei die Betriebseinheit (120) dazu eingerichtet ist, ein Stromverbrauch-Steuersignal unter Verwendung der Ausgabe von den MOSFETs für wenigstens eine Komponente in dem BMS (200) gemäß einer Ausgabe des AND-Gates und einer Ausgabespannung des Batteriepacks zu erzeugen.

2. Vorrichtung nach Anspruch 1, ferner umfassend eine Ausgabeeinheit (130), welche dazu eingerichtet ist, ein Stromverbrauch-Steuersignal, welches von der Betriebseinheit erhalten wird, zu der wenigstens einen Komponente in dem BMS (200) auszugeben.

3. Vorrichtung nach Anspruch 1, wobei die Steuerschaltung ferner einen Schalter (SWenable) zum Erzeugen eines Signals zum Aktivieren der gesamten Schaltung in der Betriebseinheit (120) gemäß einer Ausgabe des AND-Gates umfasst.

4. Vorrichtung nach Anspruch 1, wobei daraufhin, dass sowohl das Ladegerät-Verbindungssignal als auch das Aus-Signal der immer konstanten Stromquelle hoch eingegeben werden, die Betriebseinheit (120) deaktiviert wird.

5. Vorrichtung nach Anspruch 1, wobei Treiberspannungen der Mehrzahl von MOSFETs, welche in der Steuerschaltung umfasst sind, auf denselben Wert oder unterschiedliche Werte gemäß einem Betriebsziel einer individuellen Schaltung gesetzt werden, welche die MOSFETs umfasst.

6. Vorrichtung nach Anspruch 1, wobei die Widerstandswerte der Mehrzahl von Widerstandselementen, welche in der Steuerschaltung umfasst sind, auf denselben Wert oder unterschiedliche Werte gemäß einem Betriebsziel einer individuellen Schaltung gesetzt werden, welche die Widerstandselemente umfasst.

7. Batterie-Verwaltungsvorrichtung nach Anspruch 1, ferner umfassend eine Stromversorgung, welche ein Liefern von geschaltetem Strom oder immer konstantem Strom in Reaktion darauf stoppt, dass das Stromverbrauch-Steuersignal erhalten wird.

## Revendications

1. Appareil (100) pour commander la consommation de courant d'un système de gestion de batterie, BMS (200) assurant la gestion d'un bloc-batterie, l'appareil (100) comprenant :
une unité d'entrée (110) comportant une porte ET au niveau de laquelle un signal de connexion de chargeur et un signal de coupure de source d'alimentation toujours constante sont entrés, dans lequel le signal de coupure de source d'alimentation toujours constante est l'inversion d'un signal indiquant qu'une alimentation de circuits dans le BMS (200) qui sont normalement toujours alimentés doit être coupée ;
une unité de fonctionnement (120) comportant un circuit de commande, dans lequel le circuit de commande comporte une pluralité de commutateurs, une pluralité d'amplificateurs opérationnels et une pluralité d'éléments de résistance, dans lequel le circuit de commande comporte :
un premier circuit individuel comprenant :
un amplificateur opérationnel qui est configuré pour avoir une valeur de tension liée à une sortie de tension du bloc-batterie comme première entrée ; et
un MOSFET qui est configuré pour avoir la tension de sortie de l'amplificateur opérationnel comme tension d'attaque et pour émettre un signal d'alarme de microcontrôleur, MCU ;
un deuxième circuit individuel comprenant :
un amplificateur opérationnel qui est configuré pour avoir une valeur de tension liée à une sortie de tension du bloc-batterie comme première entrée ; et
un MOSFET qui est configuré pour avoir la tension de sortie de l'amplificateur opérationnel comme tension d'attaque et pour émettre un signal de coupure de source d'alimentation commutée, et
un troisième circuit individuel comprenant :
un amplificateur opérationnel qui est configuré pour avoir une valeur de tension liée à une sortie de tension du bloc-batterie comme première entrée ; et
un MOSFET qui est configuré pour avoir la tension de sortie de l'amplificateur opérationnel comme tension d'attaque et pour émettre un signal de coupure de source d'alimentation toujours constante
dans lequel chaque amplificateur opérationnel est configuré pour avoir une tension de référence comme deuxième entrée, et
dans lequel l'unité de fonctionnement (120) est configurée pour générer un signal de commande de consommation de courant en utilisant la sortie des MOSFET pour au moins un composant dans le BMS (200) selon une sortie de la porte ET et une tension de sortie du bloc-batterie.

2. Appareil selon la revendication 1, comprenant en outre une unité de sortie (130) configurée pour émettre un signal de commande de consommation de courant reçu de l'unité de fonctionnement vers l'au moins un composant dans le BMS (200).

3. Appareil selon la revendication 1, dans lequel le circuit de commande comporte en outre un commutateur (SWenable) pour générer un signal afin d'activer l'ensemble du circuit dans l'unité de fonctionnement (120) selon une sortie de la porte ET.

4. Appareil selon la revendication 1, dans lequel, lorsque le signal de connexion de chargeur et le signal de coupure de source d' alimentation toujours constante sont entrés à un niveau élevé, l'unité de fonctionnement (120) est désactivée.

5. Appareil selon la revendication 1, dans lequel les tensions d'attaque de la pluralité de MOSFET inclus dans le circuit de commande sont réglées à la même valeur ou à des valeurs différentes selon une cible de fonctionnement d'un circuit individuel comportant les MOSFET.

6. Appareil selon la revendication 1, dans lequel les valeurs de résistance de la pluralité d'éléments de résistance inclus dans le circuit de commande sont réglées à la même valeur ou à des valeurs différentes selon une cible de fonctionnement d'un circuit individuel comportant les éléments de résistance.

7. Appareil de gestion de batterie selon la revendication 1, comprenant en outre une alimentation qui coupe l'alimentation commutée ou l'alimentation toujours constante en réponse à la réception du signal de commande de consommation de courant.
